(19) Europäisches Patentamt
European Patent Office
Office européen des brevets

(11) **EP 4 168 811 B1**

(12) **EUROPÄISCHE PATENTSCHRIFT**

(45) Veröffentlichungstag und Bekanntmachung des Hinweises auf die Patenterteilung:
**02.07.2025 Patentblatt 2025/27**

(21) Anmeldenummer: **22729533.4**

(22) Anmeldetag: **16.05.2022**

(51) Internationale Patentklassifikation (IPC):
**G01R 27/18** (2006.01)    **B60L 3/00** (2019.01)
**G01R 27/02** (2006.01)

(52) Gemeinsame Patentklassifikation (CPC):
**G01R 27/18; B60L 3/0069;** B60L 2240/547;
G01R 27/025; G01R 31/52

(86) Internationale Anmeldenummer:
**PCT/EP2022/063161**

(87) Internationale Veröffentlichungsnummer:
**WO 2022/258317 (15.12.2022 Gazette 2022/50)**

(54) **ISOLATIONSÜBERWACHUNG IN EINEM HOCHSPANNUNGSSYSTEM, INSBESONDERE IN EINEM KRAFTFAHRZEUG**

INSULATION MONITORING IN A HIGH-VOLTAGE SYSTEM, IN PARTICULAR IN A MOTOR VEHICLE

SURVEILLANCE D'ISOLATION DANS UN SYSTÈME HAUTE TENSION, EN PARTICULIER DANS UN VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.06.2021 DE 102021114498**

(43) Veröffentlichungstag der Anmeldung:
**26.04.2023 Patentblatt 2023/17**

(73) Patentinhaber: **Marquardt GmbH**
**78604 Rietheim-Weilheim (DE)**

(72) Erfinder:
• **ALZNAUER, Daniel**
**79787 Lauchringen (DE)**
• **SUCHANOV-GLÜCKLER, Anton**
**78183 Hüfingen (DE)**
• **HAMMA, Andreas**
**78532 Tuttlingen (DE)**

(74) Vertreter: **Staeger & Sperling**
**Partnerschaftsgesellschaft mbB**
**Sonnenstraße 19**
**80331 München (DE)**

(56) Entgegenhaltungen:
DE-A1- 102019 214 532    US-A1- 2012 119 754
US-A1- 2019 242 932

**Beschreibung**

Die vorliegende Erfindung betrifft eine Isolationsüberwachung in einem Hochspannungssystem, insbesondere in einem Kraftfahrzeug.

In modernen Nutzfahrzeugen werden zunehmend Hochspannungssysteme eingesetzt, die mehrere hochspannungsführende Hochspannungskomponenten aufweisen. Hierbei ist es wichtig, dass die Hochspannungskomponenten einen ausreichenden Isolationswiderstand gegenüber Masse aufweisen. Es ist deshalb bekannt, den Isolationswiderstand der Hochspannungskomponenten durch ein Isolationsmessgerät zu messen, wobei eine Überwachungseinheit den gemessenen Isolationswiderstand überwacht. Bisher wurde der Messwert des Isolationswiderstands jedoch nur in relativ großen Zeitabständen gemessen.

Eine jede Isolierung beginnt sich mit zunehmendem Alter zu verschlechtern, sobald sie das erste Mal in Gerbrauch ist. Isolierungen in jedem gegebenen Anwendungsbereich sind so konstruiert, dass sie viele Jahre lang unter normalen Betriebsverhältnissen gute Dienste leisten. Jedoch haben abnormale Arbeitsverhältnisse oder zum Beispiel Unfälle bei Fahrzeugen einen schädigenden Effekt, welcher, wenn unkontrolliert gelassen, die Verschlechterung beschleunigt, schließlich einen Defekt in der Isolierung verursachen oder gar zu gefährlichen Zuständen in Fahrzeugen führen.

In elektromechanischen Batteriesystemen, insbesondere in elektrisch betriebenen Fahrzeugen, werden elektrische Lasten mit großen elektrischen Schaltern (Relais, Schütz) geschaltet. In gefährlichen Situationen, die durch Unfälle oder auch durch fehlerhafte Betriebsbedingungen entstehen können, müssen die Batteriesysteme und die außerhalb der Batteriesysteme an diese angeschlossenen Systeme (Leitungs- oder Verbraucher) geschützt werden, insbesondere auch vor einem Brand der sich dann im ganzen Fahrzeug ausbreiten kann. Der Schutz kann mit bekannten Abschaltsystemen abgesichert werden, allerdings ist dazu erforderlich, möglichst zeitnah eine Information über die Hochspannungsisolierung zu erhalten.

Ein erforderlicher Schutz ist der Hochvolt-Spannungsschutz. Dieser wird durch die Hochvoltisolierung zur umgebenden Masse sichergestellt. Durch eine abnehmende oder fehlende Hochvoltisolierung zur Masse können gefährliche Umgebungen oder Situationen, insbesondere für Personen entstehen. Ein möglicher Isolationsfehler kann unterschiedliche Ursachen haben, wie zum Beispiel Herstellung der Einzelkomponenten, Zusammenführung der Komponenten, das Zusammenschalten der Komponenten, die bereits erwähnte Alterung sowie eine fehlerhafte Bedienung

Beim Automobil wird die Masse herstellerübergreifend mit "Klemme 31" bezeichnet (Klemmenbezeichnung). Ein Isolationsfehler verursacht einen Fehlerstrom vom Hochvolt-Plus zum Hochvolt-Minus über die Klemme 31 und erzeugt dadurch Spannungsabfälle im System die gefährlich sein können. Dadurch entstehen lebensgefährliche Fehlerquellen.

Es gibt die Hochvoltbatterie als abgeschlossene Komponente selbst und die Hochvoltbatterie mit zugeschaltetem Stromkreis (über galvanische Trennelemente in Hochvolt-Plus und -Minus) mit den elektrischen Verbrauchern. Die Hochvoltbatterie für sich selbst hat im Normalfall keine Kapazitäten zur Fahrzeug-Masse. Die Hochvoltbatterie mit zugeschalteten Verbrauchern hat eine parasitäre Kapazität von der Masse zum Hochvolt-Plus und -Minus.

Die Isolationsmessung muss mit sehr kleinen Kapazitäten (wenigen nF) und mit großen Kapazitäten (einige $\mu$F) zuverlässige Messergebnisse erzeugen die das Maß für die Isolation sind. Die Isolierung wird als fehlerhaft erachtet, wenn sie den Stromfluss in ungewünschte Bahnen nicht angemessen verhindert. Das schließt Stromfluss über die inneren und äußeren Oberflächen der Isolation (Kriechstrom) und viele andere Gründe mit ein. Nadellöcher und Risse zum Beispiel können sich in der Isolierung entwickeln, oder Feuchtigkeit und andere Sachen können die Oberfläche(n) durchdringen. Diese Schadstoffe ionisieren leicht unter einer angelegten Spannung, die einen Weg für den geringen Widerstand von Kriechstrom schafft, der sich abhängig von der Verschmutzung und Umgebungsfeuchte verändern kann, verglichen mit trockenen, nicht verunreinigten Oberflächen.

Im Stand der Technik sind unterschiedliche Ströme bekannt, dessen Terminologie kurz erläutert wird. Der kapazitive Ladestrom ist der Strom, der erforderlich ist, um die Kapazität der zu prüfenden Isolation aufzuladen. Der Strom ist zunächst groß, aber relativ kurzlebig und in die Nähe des Nullwertes fallend, je nachdem wie der zu testende Gegenstand geladen ist. Ein Isolationsmaterial wird dabei genauso geladen wie ein Nichtleiter in einem Kondensator. Ein Absorptionsstrom besteht aus bis zu drei Strömen, die bei abnehmender Geschwindigkeit über einige Minuten nahe dem Nullwert fallen.

Ein Oberflächenkriechstrom ist dann vorhanden, wenn die Oberfläche der Isolierung z. B. mit Feuchtigkeit oder Salzen verunreinigt ist. Der Strom ist mit der Zeit konstant und hängt von dem Grad der vorhandenen Verschmutzung ab, die ihrerseits von der Temperatur abhängt. Dieser wird aber oft als ein einzelner Strom einschließlich mit dem Leitungsstrom unter dem gesamten Kriechstrom ignoriert. Das ist jedoch der ISO-Strom der relevant ist.

Der Isolationsmessstrom ist durch die zu betrachtende Isolierung stetig und ist normalerweise durch einen sehr hohen Widerstand parallel zur Isolierungskapazität dargestellt. Er ist Bestandteil des Kriechstroms, welcher der Strom ist, der gemessen wird, wenn die Isolierung ganz aufgeladen ist und vollständige Absorption stattgefunden hat.

Die Isolationswiderstandsmessung für elektrische Systeme nach Voltage class B (Spannungsklasse B) muss auch während der Fahrzeugkonditionierung gemessen werden unter den Bedingungen unter denen der niedrigste Wert erwartet wird. Dies erfolgt im Stand der Technik mit einem Isolationsmessgerät nach DIN EN 61557-2 VDE 0413-2:2008-02 (Elektrische Sicherheit in Niederspannungsnetzen bis AC 1 000 V und DC 1 500 V - Geräte zum Prüfen, Messen oder Überwachen von SchutzmaßnahmenTeil 2) durch messen des Isolationswiderstands bei einer Messspannung, die der HV-Spannung des Systems entspricht, so dass z. B. bei 500 V der Widerstandswert $R_{ISO\,500}$ ermittelt wird.

Nachteilig bei der Isolationsmessung ist ferner, dass eine Strommessung, an einem der Batteriepole erforderlich ist, um z. B. die Fahrstörungen zu kompensieren. Ferner muss die Strom- und Spannungsmessung an der Batterie synchronisiert werden, der vom Arbeitspunkt abhängige Widerstand der Batterie muss aus diesen Werten ermittelt werden und mit den ermittelten Werten können dann die Spannungsschwankungen rechnerisch kompensiert werden. Ferner wird die Kenntnis über die Kapazitäten benötigt.

Die kleinen und großen Kapazitäten im System beeinflussen ferner die zeitliche Dauer der Isolationsauswertung. Die Isolationsmessungen erfolgen in typischerweise zu langen Zeitfenstern bis 30 Sekunden und mehr. In der automobilen Fahrzeugtechnik hat die Isolationsauswertung in wenigen Sekunden zur Verfügung zu stehen. Die klassischen und bekannten Messmethoden mit langen Messzeiten sind nicht zielführend.

Ferner besteht ein Bedürfnis danach die Bestimmung der Isolation ohne Vorgabe der Kapazitätswerte durchführen zu können, so dass die genaue Kenntnis der Kapazität, egal ob groß oder klein, nicht notwendig ist. Ferner sollen Störungen, wie Fahrstörungen auf dem Messsignal, Laden oder Entladevorgänge nicht die Messung negativ beeinflussen.

Verschiedene Verfahren zur Ermittlung der Isolationsfestigkeit sowie Aspekte bzw. Vorrichtungen betreffend solche Verfahren sind im Stand der Technik beispielsweise durch die Dokumente US 2019/242932 A1, DE 10 2019 214532 A1 und US 2012/119754 A1 bekannt.

Der Erfindung liegt deshalb die Aufgabe zugrunde, die bekannten Hochspannungssysteme entsprechend sicher zu gestalten. Weiterhin liegt der Erfindung die Aufgabe zugrunde, ein entsprechendes Überwachungsverfahren anzugeben, welches eine schnelle Ermittlung des Zustands der Isolierung in DC-Hochspannungssystemen in Fahrzeugen ermöglicht, ohne die Kapazität des Fahrzeugs zu kennen.

Diese Aufgabe wird durch das Verfahren gemäß dem Hauptanspruch sowie die Isolationsmesseinrichtung gemäß dem nebengeordneten Anspruch 7 gelöst.

Ein Grundgedanke der vorliegenden Erfindung lässt sich in die folgenden Aspekte gliedern:
Eine Isolationsbestimmung mit erhöhter Genauigkeit und verkürzter Bestimmungszeit, kombiniert mit einer Kapazitätsberechnung in einem dreistufigen Konzept:

1) Kompensation der Fahrstörungen

2) Endwertabschätzung einer e-Funktion als Vorabberechnung

3) Iterative Optimierung des zu bestimmenden Isolationswiderstandes auf den Wert mit dem kleinsten quadratischen Fehler

Ein weiterer Aspekt der vorliegenden Erfindung betreffend der Endwertabschätzung des Isolationswiderstandes besteht darin, einen erst mit statischen Methoden nach einem bestimmten Zeitablauf (Messzeit z.B. von 30 s) ermittelbaren Wert (Isolationswert) auf Basis von Messwerten, die in kurzen Abständen (zum Beispiel alle 500 ms) ermittelt werden, als Stützstellen einer e-Funktion anzunehmen, daraus die e-funktion und deren Grenzwert zu bestimmen und aus dem Grenzwert der e-Funktion den Isolationswert (Isolationswiderstand jeweils für entweder HV-Plus zu Masse oder HV-Minus zu Masse) des Hochspannungssystems zu ermitteln. Aufgrund des jeweils charakteristischen Verlaufs der entsprechenden e-Funktion, lässt sich der Grenzwert aus einer e-Funktion extrapolieren und kann daher eine Endwertabschätzung als Vorberechnung durchgeführt werden.

Die mit der Erfindung zu erzielenden weiteren Vorteile lassen sich wie folgt angeben:

- Der ermittelte Widerstands-Isolationswert weist geringe Toleranz auf und damit eine hohe Ergebnisqualität
- Bestimmung der Kapazitäten möglich
- Isolationswertermittlung unabhängig von den Kapazitätswertangaben welche im System (Fahrzeug) verbaut sind
- Die Isolationswertbestimmung reagiert auf sich verändernde Kapazitätswerte (Kapazitätswertänderungen durch Alterungsvorgänge des Fahrzeuges, bauliche Veränderungen zum Beispiel des Kabelbaumes, Einbau von Zusatzgeräten)
- Mit dem ermittelten Endwert wird das System informiert ob die Isolationsqualität ausreichend ist und ob der Antrieb gestartet werden kann und im laufenden Betrieb weiterverwendet werden kann.

Die vorliegende Erfindung schlägt hierzu für das dreistufige Verfahren folgende Vorgehensweise vor:

1) Kapazitätsberechnung

Hierzu sind folgende Messgrößen heran zu ziehen:

- Messwerte der Batteriespannung zwischen HV-Pluspol und HV-Minuspol der Batterie erfassen
- Messwerte für die Spannung von Fahrzeugmasse zum Batteriepotential (HV-Pluspol) bzw. HV-Minus in Bezug auf Klemme 31 aufnehmen.
- Filterung des Messwertes der Batteriespannung, so dass das Frequenzverhalten je nach Fahrzustand, Laden/Entladen und Belastung der Batteriespannung der Spannung Fahrzeugmasse zum Batteriepol (HV-Pluspol) entspricht. Anders ausgedrückt bedeutet dies, den Wert zu erhalten, bei dem die Spannung zwischen HV-Pluspol und HV-Minuspol der Spannung zwischen Masse und HV-Pluspol entspricht.

Somit ist es nach der Idee der Erfindung vorgesehen die folgenden Messwerte zu erfassen: Den ungefilterter Batteriespannungsmesswert, den gefilterten Batteriespannungsmesswert mit gleichem Verhalten bzw. Frequenzverhalten wie die Batteriespannung zwischen Fahrzeugmasse zum Batteriepol HV-Plus und die Spannung zwischen Fahrzeugmasse zum Batteriepol HV-Minus.

Es erfolgt auf dieser Basis eine Berechnung nach einem geeigneten Berechnungsalgorithmus, der bevorzugt wie folgt aussehen kann:

- Erfassen der Spannung von Fahrzeugmasse zum Batteriepotential (HV-Pluspol) aufnehmen
- Berechnung der Größe Vx_comp[n] wie folgt:

$$Vx\_comp[\text{n}] = \frac{1}{2}(Vbatmean[n] - Vbat\_dc[n]) + Vx\_dc[n]$$

wobei

| | |
|---|---|
| Vx_comp[n]: | die kompensierte Messspannung darstellt, bei der die |
| Spannungen | bedingt durch Fahrstörungen bereits herausgerechnet sind |
| Vbatmean[m]: | Gefilterter Batteriespannungsmesswert mit Frequenzverhalten gleich der Batteriespannung Fahrzeugmasse zum Batteriepol |
| Vbat_dc[n]: | Ungefilterter Batteriespannungsmesswert |
| Vx_dc[n]: | Ungefilterte Spannung Fahrzeugmasse zum Batteriepol |

2) Endwertabschätzung einer e-Funktion als Vorabberechnung

Ein weiterer Aspekt der Erfindung besteht darin, die e-Funktion zu nutzen um mit deren Eigenschaft die Endwerte vorher zu bestimmen.

Die e-Funktion kann zum Beispiel mittels geeigneter Stützstellen bestimmt werden. Mit der Endwertabschätzung ist die iterative Endwertberechnung in verkürzter Zeit unterstützt.

3) Iterative Optimierung des zu bestimmenden Isolationswiderstandes

In diesem Schritt nähert man sich iterativ dem optimierten Endwert der e-Funktion an, um daraus den Isolationswiderstand möglichst genau zu bestimmen. Die Endwertabschätzung ist der Startwert für die nachfolgende Endwertberechnung und hat den Vorteil, dass die Endwertberechnung auf einem reduzierten quadratischen Fehlerniveau beginnt.

Dazu kann mit Vorteil die folgende Gleichung herangezogen werden:

$$Y(t) = A\, e^{\left(\frac{t}{tau}\right)} + EE$$

wobei folgende Größen betrachtet werden:

| | |
|---|---|
| Y: | Messwerte |
| A: | Parameter |
| Tau: | Parameter Zeitkonstante |
| EE: | Endwert e-Funktion |

t:      Messzeit.

Man geht von einer vorberechneten Pseudoinversen aus. Für EE wird ein Startwert für die iterative Berechnung verwendet. In der Regel ein vergleichsweise großer Anfangswert für den Isolationswiderstand.

Die vorstehend offenbarten Merkmale sind dabei beliebig kombinierbar, soweit dies technisch bei der Umsetzung der Erfindung sinnvoll möglich ist und diese nicht im technischen Widerspruch zueinanderstehen, auch wenn diese Kombination der Merkmale nicht ausdrücklich offenbart ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Fig. 1   eine schematische konstruktive Ausgestaltung der Erfindung
Fig. 2   eine Flow-Chart, welches die Verfahrensschritte zur Ermittlung der Isolationsfestigkeit zeigt und
Fig. 3   schematische Kurven 1 bis 4, welche zur Erläuterung der iterativen Berechnung herangezogen wurden.

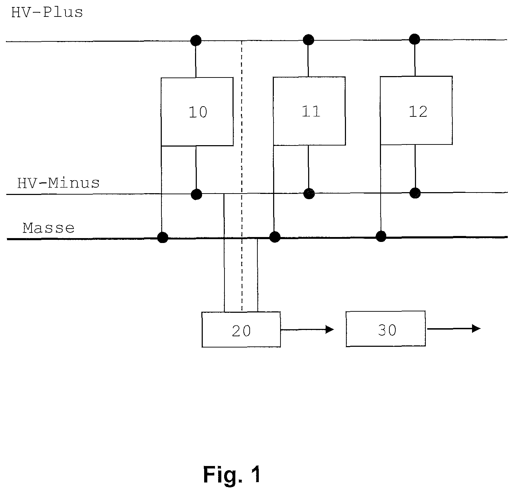

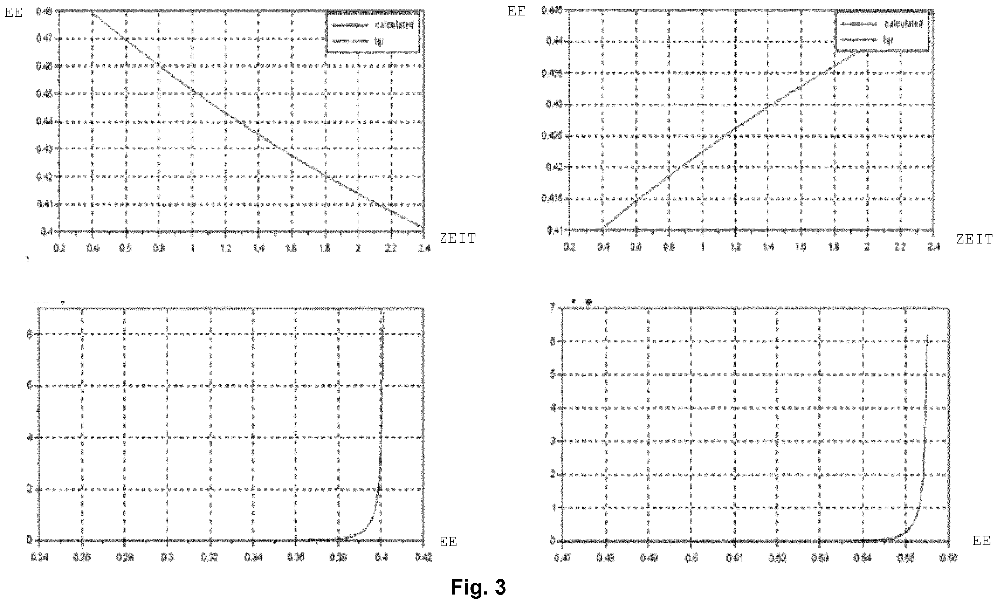

Die Figuren und Kurven sind lediglich beispielhaft schematisch. Gleiche Bezugszeichen in den Figuren weisen auf gleiche funktionale und/oder strukturelle Merkmale hin. Die Erfindung wird nachfolgend mit Bezug auf die Fig. 1 bis 3 anhand beispielhafter Ausführungsformen näher erläutert.

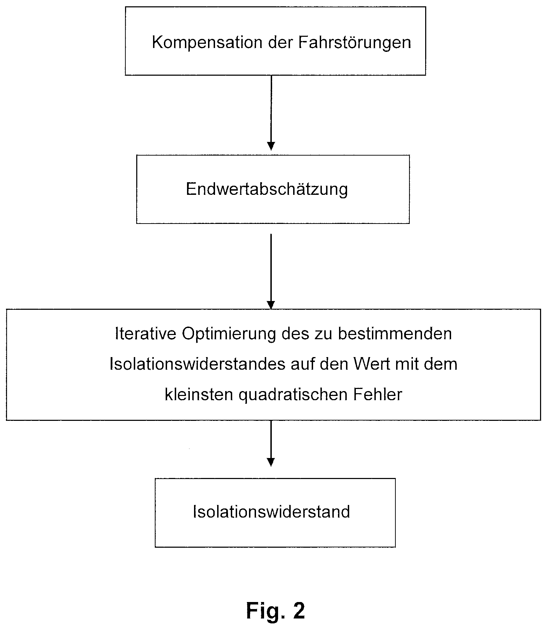

Die Fig. 2 zeigt einen Flow-Chart, welcher die dreistufige Konzeption zur Ermittlung der Isolationsfestigkeit zeigt.

In der Figur 1 ist eine rein schematische konstruktive Ausgestaltung der Erfindung anhand einem beispielhaften DC-Hochspannungssystem, insbesondere in einem Kraftfahrzeug, mit mehreren Hochspannungskomponenten 10, 11, 12 gezeigt, wobei ein nicht näher dargestellter Hochspannungsenergiespeicher vorgesehen ist, der jeweils über eine elektrische Leitung mit den die Hochspannungskomponenten 10, 11, 12 verbunden ist, sowie eine Isolationsmesseinrichtung 20 zur Messung der Spannung zwischen HV-Plus bzw. HV-Minus der Hochspannungskomponenten 10, 11, 12 und jeweils der Fahrzeugmasse und mindestens eine Auswerteeinheit 30 zur Ermittlung des Isolationswiderstands auf Basis einer iterativen Berechnung, wie diese im folgenden beispielhaften Algorithmus zur iterativen Optimierung des zu bestimmenden Isolationswiderstandes erläutert ist. Die Erfindung beschränkt sich aber nicht auf genau diese Lösung, sondern es sind auch andere iterative Ansätze denkbar.

Dazu kann mit Vorteil die folgende Gleichung herangezogen werden:

$$Y\left(t\right) = A\,e^{\left(\frac{t}{tau}\right)} + EE$$

wobei folgende Größen betrachtet werden:

Y:      Messwerte
A:      Parameter
Tau:    Parameter Zeitkonstante
EE:     Endwert e-Funktion
t:      Messzeit.

Man geht von einer vorberechneten Pseudoinversen aus. Für EE wird ein Startwert für die iterative Berechnung verwendet. In der Regel ein vergleichsweise großer Anfangswert für den Isolationswiderstand.

**Schritt 1:**

In einem ersten Schritt erfolgt nun die Linearisierung der e-Funktion durch Logarithmierung, wie folgt:

$$\ln(Y\left(t\right) - EE) = \ln(A\,e^{-\left(\frac{t}{tau}\right)})$$

$$\ln(Y\left(t\right) - EE) = \ln(A) + t/tau$$

Dadurch hat das Lösungssystem nun die Form einer linearen Gleichung der allgemeinen Form:

$$\mathrm{B} = \mathrm{A} * \mathrm{x}$$

$$\begin{bmatrix} ln(Y(t0) - EE) \\ \vdots \\ ln(Y(tn) - EE) \end{bmatrix} = \begin{bmatrix} 1 & t0 \\ \vdots & \vdots \\ 1 & tn \end{bmatrix} * \begin{bmatrix} ln(A) \\ \tau \end{bmatrix} \qquad \text{Matrix 1}$$

**Schritt 2:**

In einem nachfolgenden Schritt erfolgt die Matrix-Multiplikation mit der Pseudoinversen, wobei das Ergebnis tau und ln(A) ist.

**Schritt 3:**

In einem weiteren nachfolgenden Schritt erfolgt die Berechnung des quadratischen Fehlers (linke Seite und rechte Seite der Matrix 1).

**Schritt 4:**

In einem weiteren Schritt erfolgt die Iteration von EE:

**Schritt 5:**

In diesem Schritt erfolgt der Vergleich, ob die Kurve noch besser als Gerade genähert werden kann (bei sehr kleinen Zeitkonstanten hat das System sprungförmiges Verhalten, wobei eine Geradenlösung der bessere Ansatz ist).

- Iteration mit EE = 0
- Tau = 0
- Exp (ln(A)) ist die Lösung für die Gerade
- Quadratischer Fehler der Geradenlösung berechnen

**Schritt 6:**

Derjenige iterativ ermittelte Wert für EE, der den jeweils kleinsten quadratischen Fehler besitzt, wird für die weitere nachfolgende Berechnung verwendet. Die Parameter EE und tau werden für die Widerstandsberechnung (EE), für die Kapazitäten (Tau) berechnet. Tau bestimmt das Zeitverhalten des Systems und stellt die Filterkonstante dar.

Das Zeitverhalten des Systems in Laplace ist wie folgt:
(Beispielhaft für die Spannung zum negativen Batteriepol)

$$\frac{U_{mass\_bat}}{U_{bat}} = \frac{\left(\dfrac{R_{neg}}{R_{neg} + R_{pos}}\right) * \left(1 + s * R_{pos} * C_{pos}\right)}{1 + s * \left(\dfrac{R_{neg} * R_{pos}}{R_{neg} + R_{pos}}\right) * \left(C_{pos} + C_{neg}\right)}$$

$U_{mass\_bat}$ = Spannung der Batteriemasse zum negativen Batteriepol
$U_{bat}$ = Batteriespannung
$R_{neg}$ = negativer Isolationswiderstand
$R_{pos}$ = positiver Isolationswiderstand
$C_{neg}$ = negative Kapazität
$C_{pos}$ = positive Kapazität

Es erfolgt eine iterative Berechnung um die optimale Kombination der Werte für EE, C, A und Tau zu finden (nach dem Prinzip des kleinsten quadratischen Fehlers). Dabei wird EE pro Iteration verändert. Es könnte auch tau oder ln(A) iteriert werden. Über die Pseudoinverse wird zu einem jeweils vorgegebenen EE, das Parameterpaar A und tau berechnet, welches den kleinsten quadratischen Fehler hat.

Für die steigende und fallende Kurve wird je ein separates tau berechnet (tau1 und tau2). Um die Zeitkonstante des Mittelwert-Filters einzustellen werden beide Berechnungen von tau1 und tau2 miteinander kombiniert. Im ersten Schritt wird ein Mittelwert verwendet. In den Kurven 3 und 4 sind die quadratischen Fehler angegeben.

Mit der Endwertabschätzung wird die iterative Endwertberechnung nahe dem Optimum gestartet, d.h. mit minimalem quadratischem Fehler, wodurch das Ziel der Erfindung mit einem minimierten Zeitbedarf der Iteration, somit der Berechnung des Isolationswiderstandes möglich ist.

Mit den Ergebnissen der iterativen Endwerberechnungen (Kurven 1 und 2 bzw. Kurven 3 und 4, steigend und fallende Kurve) wird der Widerstandswert der Isolation berechnet. Mit dem Tau und den berechneten Widerstandswerten der Isolation kann man auch die Kapazitäten berechnen. Die Kurven 1, 2, 3 und 4 sind beispielhaft, wobei in den Kurven eine theoretische Kurve identisch mit der dargestellten berechneten Kurve mit dem optimalen Parameter EE ist. Die Kurven 3 und 4 zeigen den quadratischen Fehler bei jeweils dem verwendeten EE. Die Y-Achse zeigt die Spannung Fahrzeugmasse zum Batteriepol geteilt durch die Batteriespannung.

Die Widerstandsberechnung kann mit einer oder zwei Kurven erfolgen.

Die Isolationsmesseinrichtung 20 aus der Figur 1 ist demnach nach einem

Ausführungsbeispiel der Erfindung zur Bestimmung der Isolationsfestigkeit der elektrischen Isolation von den DC-Hochspannungskomponenten 10, 11, 12 in dem DC-Hochspannungssystem ausgebildet, insbesondere für ein solches Hochspannungssystem in einem Fahrzeug aufweisend einen elektrischen DC-Energiespeicher, wobei die Auswerteeinheit 30 konkret ausgebildet ist, die Messwerte von der Isolationsmesseinrichtung 20 gemäß dem zuvor beschriebenen Verfahren zu verarbeiten, um daraus den Isolationswiderstand des DC-Hochspannungssystems zu bestimmen.

Die Erfindung wird durch die begefügten Ansprüche definiert.

**Patentansprüche**

1. Verfahren zur Ermittlung der Isolationsfestigkeit der elektrischen Isolation von DC-Hochspannungskomponenten (10, 11, 12) in einem DC-Hochspannungssystem, insbesondere für ein Hochspannungssystem in einem Fahrzeug aufweisend einen elektrischen DC-Energiespeicher mit den folgenden Schritten:

   a) Ermittlung des Einflusses der Kompensationsgrößen der im Fahrzeug auftretenden Fahrstörungen auf die zu ermittelnden Isolationsfestigkeit;
   b) Durchführen einer Endwertabschätzung des Isolationswiderstandes auf Basis einer e-Funktion als Vorabberechnung zur Verwendung als Anfangswert einer nachfolgenden iterativen Berechnung und
   c) iterative Ermittlung des zu bestimmenden Isolationswiderstandes mithilfe der Optimierung des kleinsten quadratischen Fehlers für den Isolationswiderstand.

2. Verfahren nach Anspruch 1, wobei als e-Funktion die folgende Gleichung herangezogen wird:

$$Y(t) = A\, e^{\left(\frac{t}{tau}\right)} + EE$$

   wobei folgende Größen verwendet werden

   Y: erfasste Messwerte
   A: Parameter
   Tau: Zeitkonstante
   EE: Endwert e-Funktion
   t: Messzeit.

3. Verfahren nach einem der vorhergehenden Ansprüche, **dadurch gekennzeichnet, dass** die Kapazität des DC-Hochspannungssystem in dem Fahrzeug rechnerisch ermittelt wird.

4. Verfahren nach einem der vorhergehenden Ansprüche, **dadurch gekennzeichnet, dass** als Messwerte die Batteriespannung zwischen HV-Pluspol und HV-Minuspol des DC-Energiespeichers erfasst werden, sowie Messwerte für die Spannung von Fahrzeugmasse zum Batteriepotential (HV-Pluspol) aufgenommen werden und vorzugsweise die Filterung des Messwertes der Batteriespannung erfolgt, so dass das Frequenzverhalten der Batteriespannung der Spannung Fahrzeugmasse zum Batteriepol (HV-Pluspol) entspricht.

5. Verfahren nach dem vorhergehenden Anspruch, **dadurch gekennzeichnet, dass** bei der Ermittlung der Kompensationsgrößen folgende Berechnung der Größe Vx_comp[n] herangezogen wird:

$$Vx\_comp[n] = \frac{1}{2}(Vbatmean[n] - Vbat\_dc[n]) + Vx\_dc[n]$$

wobei

Vx_comp[n]: die kompensierte Messspannung darstellt, bei der die Spannungen bedingt durch Fahrstörungen bereits herausgerechnet sind
Vbatmean[m]: Gefilterter Batteriespannungsmesswert mit Frequenzverhalten gleich der Batteriespannung Fahrzeugmasse zum Batteriepol
Vbat_dc[n]: Ungefilterter Batteriespannungsmesswert
Vx_dc[n]: Ungefilterte Spannung Fahrzeugmasse zum Batteriepol.

**6.** Verfahren nach einem der vorhergehenden Ansprüche, **dadurch gekennzeichnet, dass** folgende Schritte durchgeführt werden

a. In einem anfänglichen Schritt erfolgt die Linearisierung der e-Funktion durch Logarithmierung, wie folgt:

$$\ln(Y(t) - EE) = \ln\left(A\, e^{\left(\frac{t}{tau}\right)}\right)$$

$$\ln(Y(t) - EE) = \ln(A) + t/tau$$

wodurch ein der Berechnung zu Grunde liegendes Lösungssystem nun die Form einer linearen Gleichung der allgemeinen Form besitzt:

$$B = A * x$$

$$\begin{bmatrix} ln(Y(t0) - EE) \\ \vdots \\ ln(Y(tn) - EE) \end{bmatrix} = \begin{bmatrix} 1 & t0 \\ \vdots & \vdots \\ 1 & tn \end{bmatrix} * \begin{bmatrix} \ln(A) \\ \tau \end{bmatrix}$$

b. In einem nachfolgenden Schritt erfolgt die Matrix-Multiplikation aus Schritt a) mit der Pseudoinversen, wobei das Ergebnis tau (Zeitkonstante) und die Größe ln(A) ist;
c. In einem nachfolgenden Schritt erfolgt die Berechnung des quadratischen Fehlers;
d. dann erfolgt die Iteration von EE;
e. optional erfolgt der Vergleich, ob die ermittelte Kurve noch besser als Gerade genähert werden kann und
f. dann wird der iterativ ermittelte Wert für EE, der den jeweils kleinsten quadratischen Fehler besitzt, für die weitere nachfolgende Berechnung zur Ermittlung der Isolationsfestigkeit verwendet und optional zur rechnerischen Bestimmung der Kapazität des Systems.

**7.** Isolationsmesseinrichtung (20) zur Bestimmung der Isolationsfestigkeit der elektrischen Isolation von DC-Hochspannungskomponenten (10, 11, 12) in einem DC-Hochspannungssystem, wobei die Isolationsmesseinrichtung (20) mit mindestens einer Auswerteeinheit (30) ausgebildet ist, die ausgebildet ist, die Messwerte von der Isolationsmesseinrichtung (20) gemäß dem Verfahren nach einem der Ansprüche 1 bis 6 zu verarbeiten, um daraus den Isolationswiderstand des DC-Hochspannungssystems zu bestimmen.

## Claims

**1.** A method for ascertaining the insulation strength of the electrical insulation of DC high-voltage components (10, 11, 12) in a DC high-voltage system, in particular for a high-voltage system in a vehicle having an electrical DC energy store, with the following steps:

a) ascertaining the influence of the compensation variables of the driving disturbances occurring in the vehicle on the insulation strength to be ascertained;

b) performing a final value estimation of the insulation resistance based on an e-function as a preliminary calculation for use as an initial value of a subsequent iterative calculation, and
c) iteratively ascertaining the insulation resistance to be determined by means of optimising the least squared error for the insulation resistance.

2. The method of claim 1, wherein the following equation is utilised as the e-function:

$$Y(t) = Ae^{\left(\frac{t}{tau}\right)} + EE$$

wherein the following variables are used

Y: sensed measurement values
A: parameter
Tau: time constant
EE: e-function final value
t: measuring time.

3. The method of any one of the preceding claims, **characterised in that** the capacitance of the DC high-voltage system in the vehicle is ascertained by way of calculation.

4. The method of any one of the preceding claims, **characterised in that** the battery voltage between the HV positive pole and HV negative pole of the DC energy store are sensed as measurement values, as well as measurement values for the voltage from vehicle earth to battery potential (HV positive pole) are acquired, and preferably, the filtering of the measurement value of the battery voltage takes place so that the frequency response of the battery voltage corresponds to the vehicle earth to battery pole (HV positive pole) voltage.

5. The method of the preceding claim, **characterised in that** the following calculation of the variable Vx_comp[n] is utilised in ascertaining the compensation variables:

$$Vx\_comp[n] = \frac{1}{2}(Vbatmean[n] - Vbat\_dc[n]) + Vx\_dc[n])$$

wherein

Vx_comp[n]: represents the compensated measuring voltage at which the voltages contingent upon driving disturbances have already been calculated out
Vbatmean[n]: filtered battery voltage measurement value with frequency response equal to the vehicle earth to battery pole battery voltage
Vbat_dc[n]: unfiltered battery voltage measurement value
Vx_dc[n]: unfiltered vehicle earth to battery pole voltage.

6. The method of any one of the preceding claims, **characterised in that** the following steps are performed

a. in an initial step, the linearisation of the e-function takes place by logarithmising as follows:

$$\ln(Y(t) - EE) = \ln(Ae^{\left(\frac{t}{tau}\right)})$$

$$\ln(Y(t) - EE) = (\ln(A) + t/tau$$

whereby a solution system underlying the calculation now has the form of a linear equation of the general form:

$$B = A * x$$

$$\begin{bmatrix} \ln(Y(t0) - EE) \\ \vdots \\ \ln(Y(tn) - EE) \end{bmatrix} = \begin{bmatrix} 1 & t0 \\ \vdots & \vdots \\ 1 & tn \end{bmatrix} * \begin{bmatrix} \ln(A) \\ \tau \end{bmatrix}$$

b. in a subsequent step, the matrix multiplication from step a) takes place with the pseudoinverse, wherein the result is tau (time constant) and the variable ln(A);

c. in a subsequent step, the calculation of the squared error takes place;

d. then the iteration of EE takes place;

e. optionally, the comparison takes place as to whether the ascertained curve can be approximated even better as a straight line, and

f. then the iteratively ascertained value for EE, which has the respectively least squared error, is used for the further subsequent calculation for ascertaining the insulation strength and optionally for the determination of the capacitance of the system by way of calculation.

**7.** An insulation measuring device (20) for determining the insulation strength of the electrical insulation of DC high-voltage components (10, 11, 12) in a DC high-voltage system, wherein the insulation measuring device (20) is configured with at least one evaluation unit (30) configured to process the measurement values from the insulation measuring device (20) according to the method of any one of claims 1 to 6 in order to determine the insulation resistance of the DC high-voltage system therefrom.

**Revendications**

**1.** Procédé permettant de déterminer la résistance d'isolation de l'isolation électrique de composantes haute tension CC (10, 11, 12) dans un système haute tension CC, en particulier pour un système haute tension dans un véhicule présentant un accumulateur d'énergie électrique CC, comprenant les étapes suivantes consistant à :

a) déterminer l'influence des grandeurs de compensation des perturbations de conduites apparaissant dans le véhicule sur la résistance d'isolation à déterminer ;

b) effectuer une estimation de valeur finale de la résistance d'isolation sur la base d'une fonction exponentielle comme calcul préalable pour une utilisation en tant que valeur initiale d'un calcul itératif consécutif, et

c) déterminer de manière itérative la résistance d'isolation à déterminer à l'aide de l'optimisation de l'erreur des moindres carrés pour la résistance d'isolation.

**2.** Procédé selon la revendication 1, dans lequel l'équation suivante est utilisée comme fonction exponentielle :

$$Y(t) = A\, e\left(\frac{t}{tau}\right) + EE$$

dans laquelle les grandeurs suivantes sont utilisées

Y : valeurs de mesure détectées
A : paramètres
Tau : constante de temps
EE : valeur finale de fonction exponentielle
t : temps de mesure.

**3.** Procédé selon l'une quelconque des revendications précédentes, **caractérisé en ce que** la capacité du système haute tension CC dans le véhicule est déterminée par calcul.

**4.** Procédé selon l'une quelconque des revendications précédentes, **caractérisé en ce que** comme valeurs de mesure, la tension de batterie entre le pôle positif HV et le pôle négatif HV de l'accumulateur d'énergie CC est détectée, et des valeurs de mesure pour la tension de la masse du véhicule par rapport au potentiel de batterie (pôle positif HV) sont enregistrées, et de préférence le filtrage de la valeur de mesure de la tension de batterie est effectué de sorte que la réponse en fréquence de la tension de batterie correspond à la tension de masse du véhicule par rapport au pôle de batterie (pôle positif HV).

**5.** Procédé selon la revendication précédente, **caractérisé en ce que** lors de la détermination des grandeurs de compensation, le calcul suivant de la grandeur Vx_comp[n] est utilisé :

$$Vx_{comp[n]} = \frac{1}{2}(Vbatmean[n] - Vbat\_dc[n]) + Vx\_dc[n]$$

où

Vx_comp[n] : est la tension de mesure compensée à laquelle les tensions dues aux perturbations de conduite ont déjà été éliminées par calcul,
Vbatmean[n] : est la valeur de mesure filtrée de la tension de batterie ayant une réponse en fréquence égale à la tension de batterie de la masse du véhicule par rapport au pôle de batterie,
Vbat_dc[n] : est valeur de mesure de tension de batterie non filtrée,
Vx_dc[n] : est tension non filtrée de la masse du véhicule par rapport au pôle de batterie.

**6.** Procédé selon l'une quelconque des revendications précédentes, **caractérisé en ce que** les étapes suivantes sont effectuées

a) Lors d'une étape initiale, la linéarisation de la fonction exponentielle est effectuée par calcul du logarithme comme suit :

$$In(Y(t) - EE) = In\left( A\, e\left(\frac{t}{tau}\right)\right)$$

$$In(Y(t) - EE) = In(A) + t/tau$$

de sorte qu'un système de résolution à la base du calcul se présente alors sous la forme d'une équation linéaire de la forme générale suivante :

$$B = A * x$$

$$\begin{bmatrix} In(Y(t0) - EE) \\ \vdots \\ In(Y(tn) - EE) \end{bmatrix} = \begin{bmatrix} 1 & t0 \\ \vdots & \vdots \\ 1 & tn \end{bmatrix} * \begin{bmatrix} In(A) \\ \tau \end{bmatrix}$$

b) dans une étape suivante, la multiplication de la matrice de l'étape a) par des pseudo-inverses a lieu, le résultat étant tau (constante de temps) et la grandeur In(A) ;
c) dans une étape suivante, le calcul de l'erreur quadratique a lieu ;
d) ensuite, l'itération d'EE a lieu ;
e) en option, la comparaison a lieu si la courbe déterminée peut être approximée encore mieux que la droite, et
f) ensuite, la valeur établie de manière itérative pour EE qui présente respectivement la plus petite erreur quadratique est utilisée pour le calcul consécutif pour déterminer la résistance d'isolation et en option pour déterminer par calcul la capacité du système.

**7.** Dispositif de mesure d'isolation (20) permettant de déterminer la résistance d'isolation de l'isolation électrique de composantes haute tension CC (10, 11, 12) dans un système haute tension CC, dans lequel le dispositif de mesure d'isolation (20) est réalisé avec au moins une unité d'évaluation (30) qui est réalisée pour traiter les valeurs de mesure du dispositif de mesure d'isolation (20) selon le procédé selon l'une quelconque des revendications précédentes 1 à 6 pour en déterminer la résistance d'isolation du système haute tension CC.

HV-Plus

HV-Minus

Masse

| 10 | 11 | 12 |

| 20 | → | 30 | →

**Fig. 1**

Kompensation der Fahrstörungen

Endwertabschätzung

Iterative Optimierung des zu bestimmenden
Isolationswiderstandes auf den Wert mit dem
kleinsten quadratischen Fehler

Isolationswiderstand

# Fig. 2

**Fig. 3**

EP 4 168 811 B1

**EP 4 168 811 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2019242932 A1
- DE 102019214532 A1
- US 2012119754 A1